# EUROPEAN PATENT SPECIFICATION

(11) **EP 4 142 450 B1**
(45) Date of publication and mention of the grant of the patent: **04.11.2026**
(21) Application number: 20932422.7
(22) Date of filing: 22.04.2020
(51) Int. Cl.: G05B 19/4062, H05K 13/02

(54) **CONTROL DEVICE, MOUNTING SYSTEM, AND CONTROL METHOD**
STEUERUNGSVORRICHTUNG, MONTAGESYSTEM UND STEUERUNGSVERFAHREN
DISPOSITIF DE COMMANDE, SYSTÈME DE MONTAGE, ET PROCÉDÉ DE COMMANDE

(43) Date of publication of application: 01.03.2023
(73) Proprietor: Fuji Corporation, Chiryu-shi, Aichi 472-8686 (JP)
(72) Inventor: MIYAZAKI, Shingo, Chiryu-shi, Aichi 472-8686 (JP); KUMAZAWA, Hideyuki, Chiryu-shi, Aichi 472-8686 (JP)
(74) Representative: Grünecker Patent- und Rechtsanwälte PartG mbB
(86) International application number: PCT/JP2020/017317
(87) International publication number: WO 2021/214908

(56) References cited:
- WO-A1-2017/141366
- JP-A- 2005 047 314
- US-A1- 2012 297 872
- US-A1- 2013 241 460
- US-A1- 2019 053 408

## Description

### Technical Field

The present invention relates to a control device, a mounting system, and a control method.

### Background Art

In the related art, as this type of technology, a robot system including a motor, a transmission system for transmitting the rotation of the motor, an arm driven via the transmission system, an end effector provided on the arm, on which a workpiece can be mounted, and a controller for driving the motor has been proposed (refer to Patent Literature 1, for example). Examples of the transmission system include a deceleration device, a belt, a pulley, and a bearing. In this robot system, the controller obtains a first acceleration of the end effector from the rotation speed of the motor to be obtained from the encoder of the motor, obtains a second acceleration of the end effector from the acceleration data of the acceleration sensor mounted on the end effector, and determines that the rattle and the slip of the transmission system are increased when the difference between the first acceleration and the second acceleration is larger than a threshold value.
US 2013/241460 A1 relates to drive control for a servo motor. In particular, an encoder attached to the servo motor detects an acceleration of the servo motor. A warning is output when the acceleration is outside a range.
US 2019/053408 A1 shows detecting a rotation angle of a timing pulley in a component mounting line. The timing pulley moves together with an automatic exchanging device for exchanging feeders while maintaining in an engaged state with the teeth of timing.

### Patent Literature

Patent Literature 1: JP-A-2010-64232

### Summary of the Invention

### Technical Problem

In the robot system described above, the controller requires to obtain two accelerations in order to determine whether there is an error in the transmission system. In addition, since the difference between the first acceleration and the second acceleration includes an influence of the transmission of the rotation between the motor and the transmission system, an influence of the transmission of the rotation between the transmission system and the end effector, or the like, there is a possibility that the controller erroneously determines whether there is an error in the transmission system itself. In consideration of the above, when a rolling member of a moving work device rolls while meshing with a guide section extending in a predetermined direction in accordance with the movement of the moving work device in the predetermined direction, it is required to provide a method capable of easily and accurately detecting an error in the meshing between the guide section and the rolling member.

It is a main object of the present disclosure to provide a control device, a mounting system, and a control method capable of easily and accurately detecting an error in the meshing between a guide section and a rolling member of a moving work device, in a case where the rolling member rolls while meshing with the guide section extending in a predetermined direction in accordance with the movement of the moving work device in a predetermined direction.

### Solution to Problem

The present disclosure employs the following means in order to achieve the above-mentioned main object.

The present invention is defined by the features of the independent claims, with preferred embodiments being specified in the dependent claims. References to embodiments which do not fall under the scope of the claims are to be understood as examples useful for understanding the invention.

In the control device of the present disclosure, the angular acceleration of the rolling member is calculated based on the signal from the rotational position sensor, and it is determined that an error has occurred in the meshing between the guide section and the rolling member when the angular acceleration of the rolling member is larger than the threshold value. As a result, it is possible to easily and accurately detect an error in the meshing between the guide section and the rolling member. Here, the rotational position sensor may be an encoder. In addition, as a factor of a meshing error, for example, mixing of foreign matter between the guide section and the rolling member or the like can be exemplified. Further, examples of the mounting-related device include a printing device for printing a viscous fluid on a processing target object, a print inspection device for inspecting a printing state or the like, a mounting device for mounting a component, a mounting inspection device for inspecting a mounting state or the like, a storage device for storing a feeder for supplying a component, a conveyance device of the processing target object, a reflow device for performing reflow processing, and the like. Examples of the processing target object include a board and a base material having a three-dimensional structure.

### Brief Description of Drawings

[Fig. 1] Fig. 1 is a configuration diagram schematically illustrating a configuration of mounting system 10.
[Fig. 2] Fig. 2 is a configuration diagram schematically illustrating configurations of mounting device 15 and loader 18.
[Fig. 3] Fig. 3 is a configuration diagram schematically illustrating a configuration of loader 18.
[Fig. 4] Fig. 4 is a configuration diagram schematically illustrating configurations of X-axis rail 18a and rolling gear 60.
[Fig. 5] Fig. 5 is a flowchart illustrating an example of an error determination routine.
[Fig. 6] Fig. 6 is an explanatory diagram illustrating an example of the states of angular velocity ωg and angular acceleration αg of rolling gear 60.

### Description of Embodiments

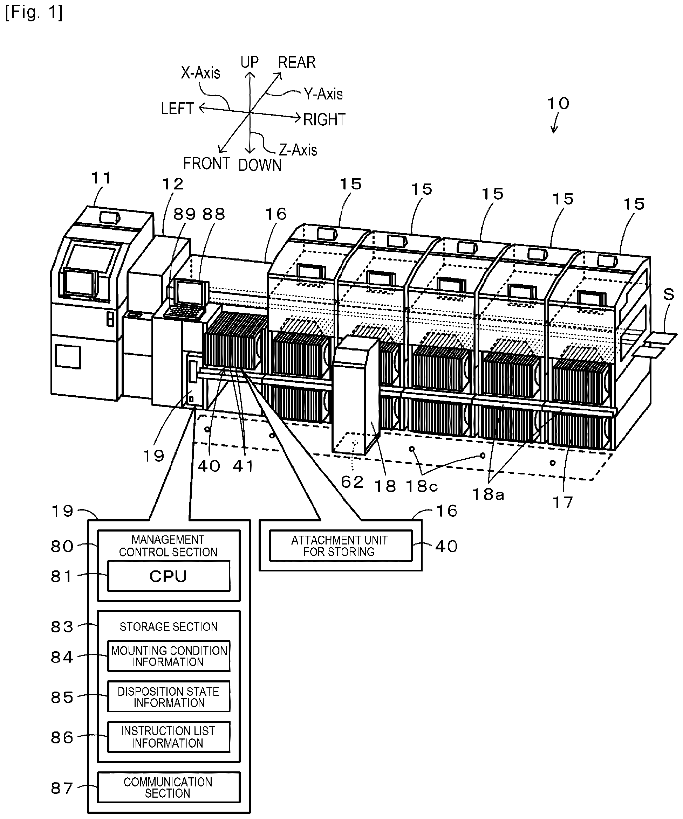

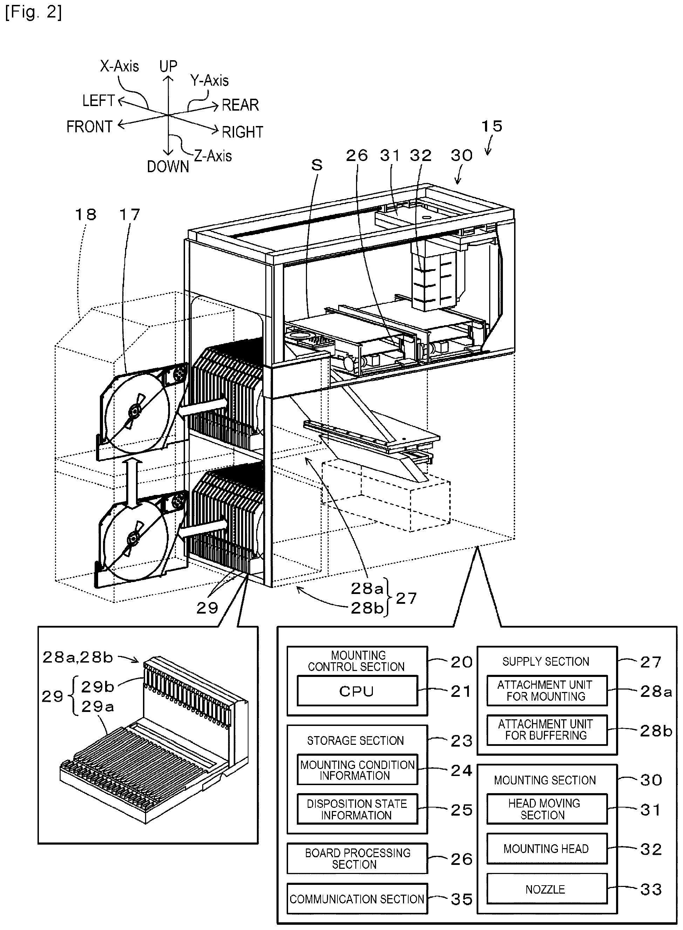

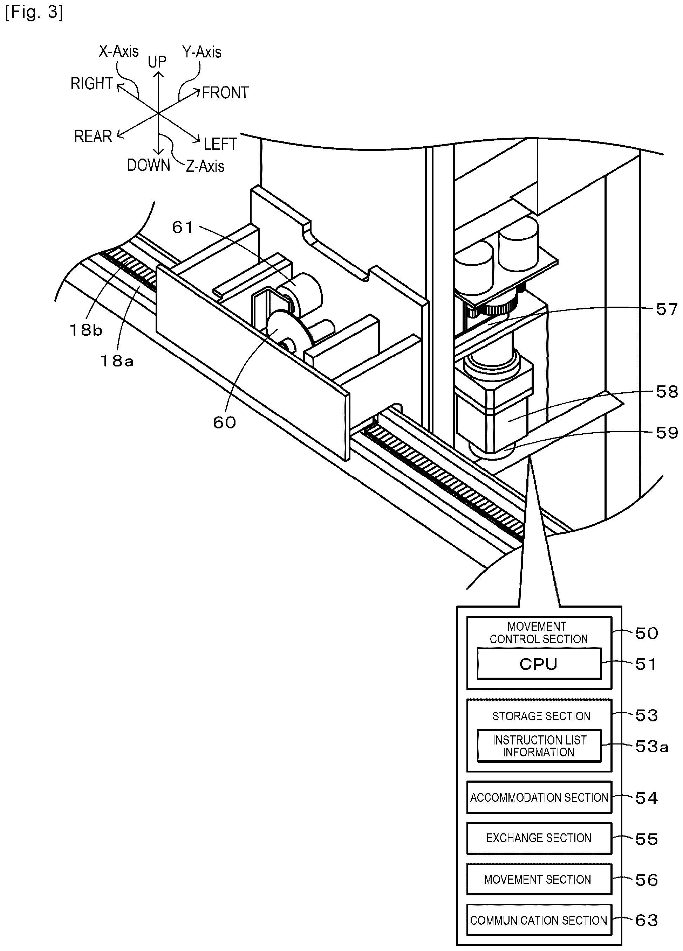

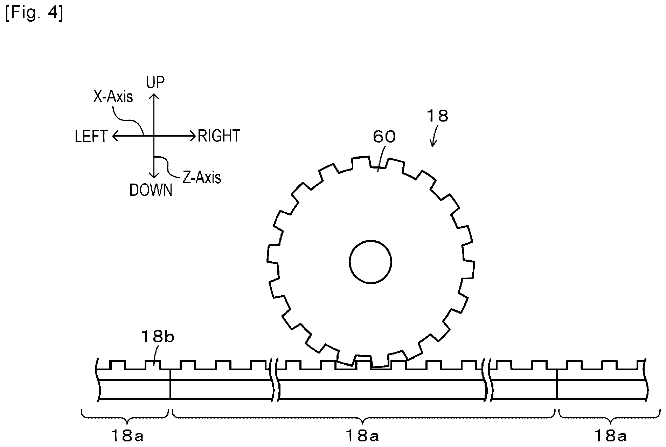

Hereinafter, the present embodiment will be described with reference to drawings. Fig. 1 is a configuration diagram schematically illustrating the configuration of mounting system 10 according to the present disclosure. Fig. 2 is a configuration diagram schematically illustrating the configuration of mounting device 15 and loader 18 serving as a moving work device. Fig. 3 is a configuration diagram schematically illustrating the configuration of loader 18. Fig. 4 is a configuration diagram schematically illustrating the configurations of X-axis rail 18a and rolling gear 60 of loader 18. In the present embodiment, the left-right direction (X-axis direction), the front-rear direction (Y-axis direction), and the up-down direction (Z-axis direction) are as illustrated in Figs. 1 to 4.

As illustrated in Fig. 1, mounting system 10 is configured as a production line in which, for example, multiple mounting devices 15 or the like for mounting components on board S serving as a mounting target object are arranged in a conveyance direction of board S. The mounting target object is not limited to board S as long as the component is to be mounted, but may be a base material having a three-dimensional shape. Mounting system 10 includes printing device 11, print inspection device 12, multiple mounting devices 15, a storage device 16, loader 18, management device 19, and the like.

Printing device 11 is a device that prints a solder paste or the like on board S. Print inspection device 12 is a device for inspecting the state of the printed solder. The multiple mounting devices 15 are arranged in the conveyance direction (X-axis direction) of board S. Each mounting device 15 is a device for picking up components and mounting the components on board S.

As illustrated in Fig. 2, each mounting device 15 includes mounting control section 20, storage section 23, board processing section 26, supply section 27, mounting section 30, and communication section 35. Mounting control section 20 is configured as a microprocessor centered on CPU 21, and controls the entire device. Mounting control section 20 outputs control signals to board processing section 26, supply section 27, and mounting section 30, and inputs signals from board processing section 26, supply section 27, and mounting section 30. Storage section 23 is, for example, an HDD or an SSD, and is a device for storing various data such as a processing program. Mounting condition information 24, disposition state information 25, and the like are stored in storage section 23. Mounting condition information 24 and disposition state information 25 are the same information as mounting condition information 84 and disposition state information 85 stored in storage section 83 of management device 19. Mounting condition information 84 is created by management device 19, transmitted from management device 19, and stored in storage section 23. Disposition state information 25 is created by mounting device 15 and stored in storage section 23. Details of mounting condition information 24 and disposition state information 25 will be described later. Communication section 35 is an interface for exchanging information with an external device such as management device 19.

Board processing section 26 is a unit that carries in, conveys, fixes and unloads board S at a mounting position. Board processing section 26 includes a pair of conveyor belts that are provided at intervals in the front-rear direction in Fig. 1 and spanned in the left-right direction. Board S is conveyed by the conveyor belts. Supply section 27 is a unit that supplies components to mounting section 30, and includes two upper and lower attachment units to which feeder 17 can be attached. The upper stage is attachment unit 28a for mounting from which a component can be picked up by mounting section 30, and the lower stage is attachment unit 28b for buffering from which a component cannot be picked up by mounting section 30. Supply section 27 may not include attachment unit 28b for buffering. Each of attachment unit 28a for mounting and attachment unit 28b for buffering includes multiple attachment sections 29 formed in an L-shape when viewed from the X-axis direction and arranged in the X-axis direction at predetermined intervals. Each of attachment sections 29 includes slot 29a into which a rail member of feeder 17 including a reel around which a tape holding a component is wound is inserted, and a connecting section 29b into which a connector provided at a distal end of feeder 17 is inserted. Feeder 17 includes a controller (not illustrated). The controller stores information such as identification information (ID) of the tape included in feeder 17, a component type, and the number of remaining components. When feeder 17 is coupled to connecting section 29b, the controller transmits the information of feeder 17 to mounting control section 20.

Mounting section 30 is a unit that picks up components from supply section 27 and disposes the components on board S fixed to board processing section 26. Mounting section 30 includes head moving section 31, mounting head 32, and nozzle 33. Head moving section 31 includes a slider guided by the guide rail and moving in an XY direction, and a motor for driving the slider. Mounting head 32 picks up one or more components and moves the components in the XY direction by head moving section 31. Mounting head 32 is detachably attached to the slider. One or more nozzles 33 are detachably attached to the lower surface of mounting head 32. Nozzle 33 picks up a component by using a negative pressure. Instead of nozzle 33, a pickup member that picks up a component may be a mechanical chuck or the like that mechanically holds a component.

As illustrated in Fig. 1, storage device 16 is a storing place for storing feeder 17 used in each mounting device 15. Storage device 16 is provided below a conveyance device between print inspection device 12 and the most upstream mounting device 15 in the conveyance direction of board S among multiple mounting devices 15. Storage device 16 includes attachment unit 40 for storing. Attachment unit 40 for storing is formed in an L-shape when viewed from the X-axis direction, similarly to attachment unit 28a for mounting and the like, and includes multiple attachment sections 41 arranged in the X-axis direction at predetermined intervals. Each of attachment sections 41 includes a slot and a connecting section similar to attachment section 29 described above, and feeder 17 can be attached.

As illustrated in Fig. 1, X-axis rails 18a are attached to the front surfaces of storage device 16 and each mounting device 15, respectively, so as to be parallel to the conveyance direction (X-axis direction) of board S and so as to be continuous in a row in the X-axis direction throughout mounting system 10. Two adjacent X-axis rails 18a may be coupled to each other. As illustrated in Figs. 3 and 4, belt 18b, which is a guide section in which unevenness is alternately formed in the extending direction of X-axis rail 18a, is attached to X-axis rail 18a. As multiple X-axis rails 18a are continuously arranged in a row in the X-axis direction, multiple belt sections 18b are also continuously arranged in a row in the X-axis direction. As illustrated in Fig. 1, multiple docks 18c serving as reference position markers are provided at intervals in the X-axis direction on the floor surface in the region of the movement of loader 18 in front of storage device 16 and each mounting device 15 (refer to the dashed line region in Fig. 1). In the embodiment, multiple docks 18c are provided one by one, corresponding to each of storage device 16 and each mounting device 15. Multiple docks 18c may be provided corresponding to each of storage device 16 and each mounting device 15, or one or multiple docks 18c may be provided in entire mounting system 10. In addition, multiple docks 18c may be embedded in the floor surface, or may be provided at a position other than belt 18b of X-axis rail 18a, for example, on the front surface or the lower surface of X-axis rail 18a.

As illustrated in Figs. 1 to 4, loader 18 is a moving work device that moves between storage device 16 and each mounting device 15 in the X-axis direction, and automatically attaches or collects feeder 17 to and from each of attachment sections 41 and 29 of storage device 16 and each mounting device 15. As illustrated in Fig. 3, loader 18 includes movement control section 50, storage section 53, accommodation section 54, exchange section 55, movement section 56, and communication section 63. Movement control section 50 is configured as a microprocessor centered on CPU 51 and controls the entire device. Movement control section 50 outputs control signals to exchange section 55 and movement section 56, and inputs signals from exchange section 55 and movement section 56. Storage section 53 is, for example, an HDD or an SSD, and is a device for storing various data such as a processing program. Storage section 53 stores instruction list information 53a and the like. Instruction list information 53a is the same information as instruction list information 86 stored in storage section 83 of management device 19, and is created by management device 19, transmitted from management device 19, and stored in storage section 53. Details of instruction list information 53a will be described later. Storage section 53 also stores the positions of multiple docks 18c in the X-axis direction.

Accommodation section 54 has an accommodation space in which feeders 17 are accommodated. Accommodation section 54 is configured to accommodate, for example, four feeders 17. Exchange section 55 is a mechanism that carries feeder 17 in and out and moves feeder 17 to upper and lower stages (refer to Fig. 2). Exchange section 55 has a clamp section for clamping feeder 17, a Y-axis slider for moving the clamp section in the Y-axis direction (the front-rear direction), and a Z-axis slider for moving the clamp section in the Z-axis direction (the up-down direction). Exchange section 55 attaches and collects feeder 17 to and from each of attachment sections 41 and 29 of storage device 16 and each mounting device 15. Movement section 56 is a mechanism for moving loader 18 in the X-axis direction (left-right direction). As illustrated in Figs. 3 and 4, movement section 56 includes driving belt 57 for moving loader 18 in the X-axis direction, X-axis motor 58 for driving driving belt 57, and rolling gear 60 which is a rolling member that rolls while meshing with the unevenness of belt 18b in accordance with the movement of loader 18 in the X-axis direction. In addition, movement section 56 includes encoder 59 that is a rotational position sensor for detecting the rotational position of X-axis motor 58, encoder 61 which is a rotational position sensor for detecting the rotational position of rolling gear 60, and passage detection sensor 62 (refer to Fig. 1) that detects the passage of loader 18 when loader 18 moves in the X-axis direction and passes through dock 18c. Passage detection sensor 62 is configured to detect the passage of dock 18c by loader 18 by communication with dock 18c, non-contact power transmission/reception, detection of a change in magnetic flux, or the like. Communication section 63 is an interface for exchanging information with external devices such as management device 19 and each mounting device 15.

In loader 18 configured in this manner, movement control section 50 calculates current position Pn of loader 18 based on the reference position which is the position of dock 18c through which loader 18 has just passed, out of multiple docks 18c, and rotation amount Ag of rolling gear 60 based on rotational position θg of rolling gear 60 detected by encoder 61. In addition, when loader 18 passes through any of multiple docks 18c, movement control section 50 updates the reference position and resets rotation amount Ag of rolling gear 60 to a value 0, thereby resetting current position Pn of loader 18 to the updated reference position. Further, movement control section 50 calculates angular velocity ωm and angular acceleration αm of X-axis motor 58 by differentiating rotational position θm of X-axis motor 58 once or twice, and also calculates angular velocity ωg and angular acceleration αg of rolling gear 60 by differentiating rotational position θg of rolling gear 60 once or twice. Movement control section 50 transmits information such as current position Pn of loader 18 and the executed work contents of the executed operation to management device 19.

Management device 19 is a device for managing information of each device of mounting system 10. As illustrated in Fig. 1, management device 19 includes management control section 80, storage section 83, communication section 87, display section 88, and input device 89. Management control section 80 is configured as a microprocessor centered on CPU 81, and controls the entire device. Storage section 83 is, for example, an HDD or an SSD, and is a device for storing various data such as a processing program. Communication section 87 is an interface for exchanging information with external devices such as each mounting device 15 and loader 18. Display section 88 is a liquid crystal screen for displaying various information. Input device 89 includes a keyboard, a mouse, and the like through which an operator inputs various commands.

As illustrated in Fig. 1, storage section 83 stores mounting condition information 84, disposition state information 85, instruction list information 86, and the like. Mounting condition information 84 is a production job of each mounting device 15, and is information including information of components, a disposition order in which components are mounted on board S, a disposition position, an attachment position (attachment section number) of feeder 17 for picking up components, and the like. Disposition state information 85 is information including the type and the use state of feeder 17 attached to each of attachment sections 41 and 29 of storage device 16 and each of mounting devices 15. The use state of feeder 17 includes a component name, the number of remaining components, and the like. Instruction list information 86 is information including contents of work to be performed by loader 18 with respect to storage device 16 and each of attachment sections 41 and 29 of each of mounting devices 15. Mounting condition information 84 is created by management device 19, stored in storage section 83, and transmitted to each mounting device 15. Disposition state information 85 is created by each mounting device 15, transmitted from each mounting device 15, and stored in storage section 83. Instruction list information 86 is created by management device 19, stored in storage section 83, and transmitted to loader 18. Disposition state information 85 and instruction list information 86 are updated with contents corresponding to the current state when loader 18 or the operator attaches and collects feeder 17 to and from each of attachment sections 41 and 29 of storage device 16 and each mounting device 15.

In mounting system 10 according to the embodiment configured as described above, mounting device 15 mounts component P on board S as follows. When the mounting processing is started, CPU 21 of mounting control section 20 reads mounting condition information 24, and carries and fixes board S into board processing section 26. Subsequently, CPU 21 causes mounting head 32 to pick up component P from feeder 17 attached to attachment section 29 of supply section 27 based on mounting condition information 24 and dispose component P on board S. When the disposition of component P with respect to board S is completed, CPU 21 causes board processing section 26 to discharge board S, and carries next board S into board processing section 26. CPU 21 manages the number of components used by each feeder 17 during the execution of the mounting processing, and transmits the information to management device 19 when the number of remaining components is equal to or less than a predetermined value. Management device 19 performs processing for adding exchange work of feeder 17 whose number of remaining components is equal to or less than a predetermined value, that is, feeder 17 that is running short of components to instruction list information 86. Management device 19 causes loader 18 to execute the exchange work of feeder 17 based on instruction list information 86. Loader 18 moves between storage device 16 and each mounting device 15 while rolling gear 60 meshes with belt 18b of X-axis rail 18a to roll, and executes the exchange work of feeder 17 with respect to storage device 16 as a work target and each of attachment sections 41 and 29 of each mounting device 15 while transmitting current position Pn of loader 18 to management device 19.

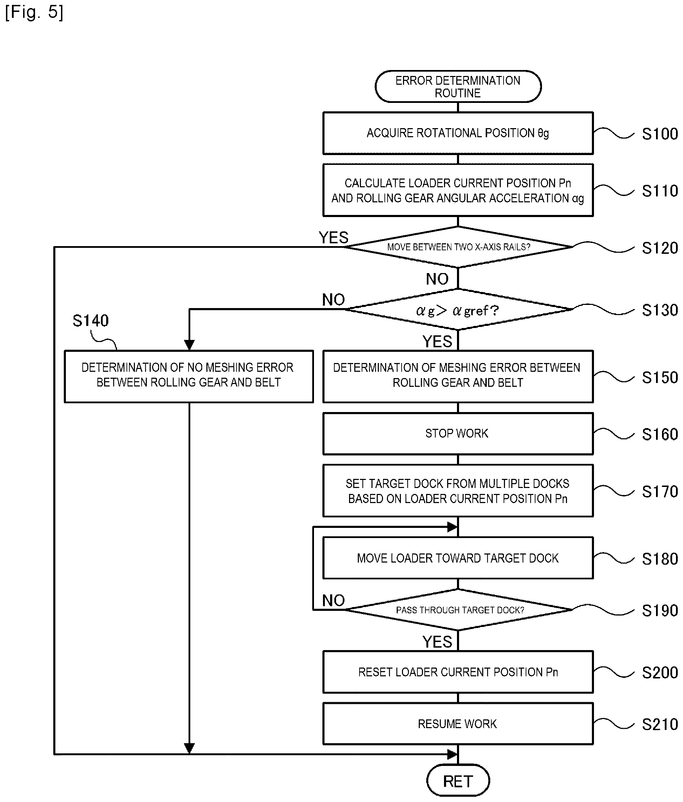

Next, the operation of mounting system 10 according to the embodiment configured as described above, particularly, the operation when determining whether there is an error in the meshing between rolling gear 60 and belt 18b will be described. Fig. 5 is a flowchart illustrating an example of an error determination routine executed by CPU 51 of movement control section 50 of loader 18. This routine is repeatedly executed.

When the error determination routine of Fig. 5 is executed, CPU 51 first acquires rotational position θg of rolling gear 60 from encoder 61 (S100), and calculates current position Pn of loader 18 and angular acceleration αg of rolling gear 60 based on acquired rotational position θp of rolling gear 60 (S110). These calculation methods are described above. Subsequently, CPU 51 determines whether loader 18 is moving between two adjacent X-axis rails 18a, that is, whether rolling gear 60 is moving between two adjacent belts 18b (S120). This processing is performed, for example, by determining whether current position Pn of loader 18 is within the end portion region of X-axis rail 18a. The meaning of this processing will be described later.

When it is determined in S120 that loader 18 is not moving between two X-axis rails 18a, CPU 51 compares angular acceleration αg of rolling gear 60 with threshold value αgref (S120). Here, threshold value αgref is a threshold value used to determine whether an error has occurred in the meshing between rolling gear 60 and belt 18b. Examples of the cause of an error in the meshing of rolling gear 60 with belt 18b include the mixing of unnecessary components and foreign matter such as dust between rolling gear 60 and belt 18b. When angular acceleration αg of rolling gear 60 is equal to or less than threshold value αgref in S120, CPU 51 determines that an error has not occurred in the meshing between rolling gear 60 and belt 18b (S130), and ends the present routine. When angular acceleration αg of rolling gear 60 is larger than threshold value αgref in S120, CPU 51 determines that an error has occurred in the meshing between rolling gear 60 and belt 18b (S140).

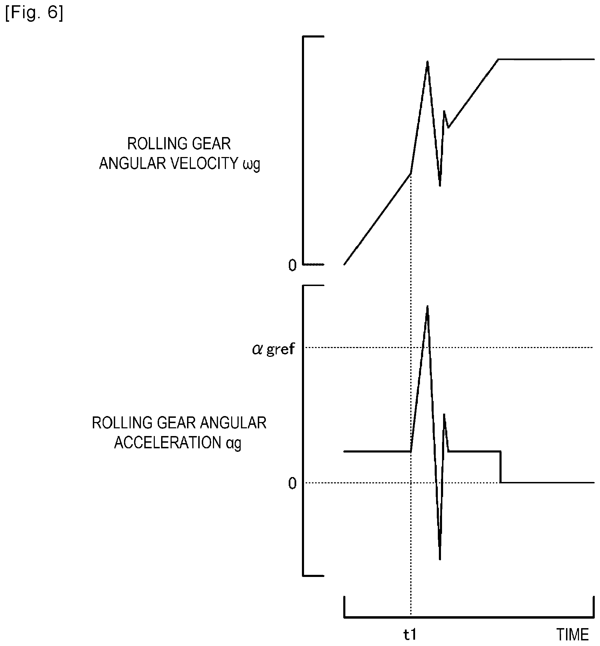

Fig. 6 is an explanatory diagram illustrating an example of the states of angular velocity ωg and angular acceleration αg of rolling gear 60 when an error has occurred in the meshing between rolling gear 60 and belt 18b. As illustrated in the drawing, when rolling gear 60 rolls while meshing with belt 18b in accordance with the movement of loader 18 in the X-axis direction, if an error occurs in the meshing between rolling gear 60 and belt 18b (time t1), angular velocity ωg and angular acceleration ωg of rolling gear 60 abruptly change by the idling of rolling gear 60 or the like. However, as illustrated, when an error occurs in the meshing between rolling gear 60 and belt 18b during the acceleration of loader 18, that is, during the acceleration of rolling gear 60, angular velocity ωg of rolling gear 60 may not rise to a value at a time of subsequent constant-speed rotation. Therefore, when CPU 51 determines whether there is such a meshing error by using angular velocity ωg of rolling gear 60, it may not be possible to appropriately determine whether a meshing error. On the other hand, in the embodiment, when CPU 51 determines whether there is such a meshing error by using angular acceleration αg of rolling gear 60, it is possible to appropriately determine whether there is a meshing error. In addition, it is also conceivable that CPU 51 determines whether there is such a meshing error by using angular acceleration αm of X-axis motor 58 instead of angular acceleration αg of rolling gear 60. In this case, there is a possibility that the influence of the sliding or the like between X-axis motor 58 and driving belt 57 is included in angular acceleration αm of X-axis motor 58, and there is a possibility that CPU 51 cannot appropriately determine whether there is a meshing error. On the other hand, in the embodiment, CPU 51 can directly determine whether there is a meshing error by determining whether there is such a meshing error by using angular acceleration αg at which rolling gear 60 meshes with belt 18b. As a result, it is possible to easily and accurately detect an error in the meshing between rolling gear 60 and belt 18b.

After S140, CPU 51 stops the work with loader 18 (S160), and sets one dock 18c from multiple docks 18c (refer to Fig. 1) to a target dock (S170). The processing of S170 is performed by setting dock 18c closest to current position Pn of loader 18 among multiple docks 18c as a target dock, or by setting predetermined dock 18c, for example, dock 18c corresponding to storage device 16 as a target dock.

Subsequently, CPU 51 moves loader 18 from current position Pn to the target dock side (S190), and waits for loader 18 to pass through the target dock (S190). When loader 18 passes through the target dock, CPU 51 resets current position Pn of loader 18 (S200), resumes the stopped work by loader 18 (S210), and ends the present routine. The processing of S200 is performed by updating the position of the target dock as the reference position, resetting rotation amount Ag of rolling gear 60 to a value 0, and resetting current position Pn of loader 18 to the updated reference position.

When an error occurs in the meshing between rolling gear 60 and belt 18b, there is a possibility that current position Pn of loader 18 calculated by CPU 51 deviates from actual current position Pnact. At this time, when loader 18 continues the work based on instruction list information 86, there is a possibility that loader 18 attempts to attach feeder 17 between two adjacent attachment sections 41 and 29 of storage device 16 and each mounting device 15, attempts to attach feeder 17 on attachment sections 41 and 29 different from attachment sections 41 and 29 to which feeder 17 is to be attached, or attempts to collect feeder 17 from attachment sections 41 and 29 different from attachment sections 41 and 29 from which feeder 17 is to be collected. On the other hand, in the embodiment, when detecting an error in the meshing between rolling gear 60 and belt 18b, CPU 51 stops the work by loader 18, moves loader 18 to the target dock side set from multiple docks 18c, and resets current position Pn of loader 18 when loader 18 passes through the target dock. As a result, it is possible to suppress the inconvenience that loader 18 attempts to attach feeder 17 between two adjacent attachment sections of storage device 16 and each mounting device 15.

When it is determined in S120 that loader 18 is moving between two X-axis rails 18a, CPU 51 ends the present routine without determining whether there is an error in the meshing between rolling gear 60 and belt 18b. In the end portion region of X-axis rail 18a, a pitch, that is, an interval between the unevenness of successive parts of two adjacent belts 18b may differ from other regions. In the embodiment, when loader 18 moves between two X-axis rails 18a, it is possible to suppress an erroneous determination as to whether there is an error in the meshing between rolling gear 60 and belt 18b by not determining whether there is an error in the meshing between rolling gear 60 and belt 18b.

Here, correspondences between constituent elements of the present embodiment and constituent elements of the present disclosure will be clarified. Each mounting device 15 and storage device 16 of the present embodiment correspond to the [mounting-related device], loader 18 corresponds to the [moving work device], and movement control section 50 corresponds to the [control device].

Movement control section 50 of loader 18 used in mounting system 10 of the above-described embodiment calculates angular acceleration αg of rolling gear 60 based on rotational position θg of rolling gear 60 from encoder 61, and determines that an error has occurred in the meshing between rolling gear 60 and belt 18b of X-axis rail 18a when calculated angular acceleration αg of rolling gear 60 is larger than threshold value αgref. As a result, it is possible to easily and accurately detect an error in the meshing between rolling gear 60 and belt 18b. In addition, movement control section 50 can directly detect an error in the meshing between rolling gear 60 and belt 18b by determining whether there is an error in the meshing between rolling gear 60 and belt 18b by using not angular acceleration αm of X-axis motor 58 based on rotational position θm of X-axis motor 58 from encoder 59 but angular acceleration αg of rolling gear 60.

In addition, when detecting an error in the meshing between rolling gear 60 and belt 18b, movement control section 50 of loader 18 stops the work by loader 18, moves loader 18 to the target dock side set from multiple docks 18c, and resets current position Pn of loader 18 when loader 18 passes through the target dock. As a result, current position Pn of loader 18 can be reset.

It is obvious that the present disclosure is not limited to the above-described embodiment and can be implemented in various modes as long as the modes belong to the technical scope of the present invention.

In the above-described embodiment, when detecting an error in the meshing between rolling gear 60 and belt 18b, movement control section 50 of loader 18 moves loader 18 to the target dock side set from multiple docks 18c, and resets current position Pn of loader 18 when loader 18 passes through the target dock, but further, may notify the operator of the same by displaying error information on display section 88 of management device 19. In addition, when detecting an error in the meshing between rolling gear 60 and belt 18b, movement control section 50 may suspend the movement of loader 18 and notify the operator by displaying error information on display section 88 of management device 19.

In the above-described embodiment, when loader 18 moves between two X-axis rails 18a, that is, when rolling gear 60 moves between two belts 18b, movement control section 50 of loader 18 does not determine whether there is an error in the meshing between rolling gear 60 and belt 18b, but may determine the same.

In the above-described embodiment, encoders 59 and 61 are used as the rotational position sensors, but other sensors, such as a resolver, may be used.

In the above-described embodiment, movement control section 50 operates as a control device of loader 18, but management device 19 may operate as a control device of loader 18.

In the above-described embodiment, loader 18 and movement control section 50 operate as a moving work device and a control device, but the present invention is not limited thereto. For example, head moving section 31 and mounting control section 20 of mounting section 30 of mounting device 15 may operate as a moving work device and a control device. In addition, the Y-axis slider or the Z-axis slider of exchange section 55 of loader 18 and movement control section 50 may operate as a moving work device and a control device.

In the above-described embodiment, mounting system 10 includes printing device 11, print inspection device 12, conveyance device, each mounting device 15, storage device 16, loader 18, and management device 19. However, mounting system 10 may not include some of the same, or may include, for example, a mounting inspection device for inspecting the mounting state of board S or a component of the base material, a reflow device for performing reflow processing, or the like in addition to some or all of the same within the range capable of realizing the present disclosure.

In the above-described embodiment, the present disclosure is applied to the mode of mounting system 10, but the present disclosure may be applied to a control device or a control method of a moving work device.

Here, the control device, the mounting system, and the control method of the present disclosure may be configured as follows. For example, in the control device of the present disclosure, the moving work device may further include a motor for driving a driving belt for moving the moving work device in the predetermined direction, and a second rotational position sensor for detecting a rotational position of the motor. In this case, by using the rotational position sensor instead of the second rotational position sensor, it is possible to directly detect an error in the meshing between the guide section and the rolling member.

In the control device according to the present disclosure, the processing section may calculate a position of the moving work device based on the signal from the rotational position sensor, and when it is determined that a meshing error has occurred, the processing section may move the moving work device to a predetermined position side, and reset the position of the moving work device when the moving work device has moved to the predetermined position. Accordingly, the estimated position of the moving work device calculated based on the signal from the rotational position sensor can be reset when the estimated position of the moving work device deviates from an actual position due to a meshing error between the guide section and the rolling member.

In the control device of the present disclosure, the moving work device may include an attaching and detaching section that moves in the predetermined direction in which the multiple mounting-related devices are arranged and is capable of attaching and detaching a feeder that supplies the component to and from an attachment section of the mounting-related device, and an accommodation section for accommodating the feeder.

In this case, the processing section may calculate a position of the moving work device based on the signal from the rotational position sensor, and when it is determined that the error has occurred in the meshing, may move the moving work device to a predetermined position side, and reset the position of the moving work device when the moving work device moves to the predetermined position, and the predetermined position may be set for each of the multiple mounting-related devices. Accordingly, in a device including a multiple mounting-related devices, the estimated position of the moving work device calculated based on the signal from the rotational position sensor can be reset when the estimated position of the moving work device deviates from an actual position due to a meshing error between the guide section and the rolling member.

In addition, in this case, the multiple mounting-related devices may each include the guide section, and the processing section may not perform determination as to whether the meshing error has occurred when the moving work device moves between two guide sections. It is possible to suppress erroneous detection of a meshing error when the moving work device moves between two guide sections.

The mounting system of the present disclosure is a mounting system including a mounting-related device for executing mounting-related processing related to mounting of a component, and a moving work device that moves in a predetermined direction, in which the moving work device includes a rolling member that rolls while meshing with a guide section extending in the predetermined direction in accordance with the movement of the moving work device in the predetermined direction, and a rotational position sensor for detecting a rotational position of the rolling member, and the mounting system further includes a control device according to any one of the above modes. In the mounting system of the present disclosure, since the control device according to any one of the above modes is provided, similarly to the control device described above, it is possible to easily and accurately detect a meshing error between the guide section and the rolling member.

A control method of the present disclosure is a control method of a moving work device used in a mounting system including a mounting-related device for executing mounting-related processing related to mounting of a component and that moves in a predetermined direction, in which the moving work device includes a rolling member that rolls while meshing with a guide section extending in the predetermined direction in accordance with the movement of the moving work device in the predetermined direction, and a rotational position sensor for detecting a rotational position of the rolling member, the control method includes (a) calculating an angular acceleration of the rolling member based on the signal from the rotational position sensor, and (b) determining that an error has occurred in the meshing between the guide section and the rolling member when the angular acceleration of the rolling member is larger than a threshold value.

In the control method of the present disclosure, the angular acceleration of the rolling member is calculated based on the signal from the rotational position sensor, and it is determined that an error has occurred in the meshing between the guide section and the rolling member when the angular acceleration of the rolling member is larger than the threshold value. As a result, it is possible to easily and accurately detect an error in the meshing between the guide section and the rolling member. Here, the rotational position sensor may be an encoder. In addition, as a factor of a meshing error, for example, mixing of foreign matter between the guide section and the rolling member or the like can be exemplified. Further, examples of the mounting-related device include a printing device for printing a viscous fluid on a processing target object, a print inspection device for inspecting a printing state or the like, a mounting device for mounting a component, a mounting inspection device for inspecting a mounting state or the like, a storage device for storing a feeder for supplying a component, a conveyance device of the processing target object, a reflow device for performing reflow processing, and the like. Examples of the processing target object include a board and a base material having a three-dimensional structure.

### Industrial Applicability

The present disclosure can be used in an industry for manufacturing a mounting system and the like.

### Reference Signs List

10 mounting system
11 printing device
12 print inspection device
15 mounting device
16 storage device
17 feeder
18 loader
18a X-axis rail
18b belt
18c dock
19 management device
20 mounting control section
21 CPU
23 storage section
24 mounting condition information
25 disposition state information
26 board processing section
27 supply section
28a attachment unit for mounting
28b attachment unit for buffering
29 attachment section
29a slot
29b connecting section
30 mounting section
31 head moving section
32 mounting head
33 nozzle
35 communication section
40 attachment unit for storing
41 attachment section
50 movement control section
51 CPU
53 storage section
53a instruction list information
54 accommodation section
55 exchange section
56 movement section
57 driving belt
58 x-axis motor
59 encoder
60 rolling gear
61 encoder
62 passage detection sensor
63 communication section
80 management control section
81 CPU
83 storage section
84 mounting condition information
85 disposition state information
86 instruction list information
87 communication section
88 display section
89 input device

## Claims

1. A control device (50) configured to control a moving work device (18) used in a mounting system including mounting-related devices (15) for executing mounting-related processing related to mounting of a component,
wherein the moving work device is configured to move in a predetermined direction in which the mounting-related devices are arranged, and
wherein the moving work device includes a rolling member (60) configured to roll while meshing with a guide section (18b) of a rail (18a) attached to a front surface of each mounting related device and extending in the predetermined direction in accordance with the movement of the moving work device (18) in the predetermined direction, and
the moving work device further includes a rotational position sensor (61) configured for detecting a rotational position of the rolling member (60),
wherein the control device (50) includes a processing section configured to calculate an angular acceleration of the rolling member (60) based on a signal from the rotational position sensor (61) and determine that an error has occurred in meshing between the guide section (18b) and the rolling member (60) when the angular acceleration of the rolling member (60) is larger than a threshold value, and
the processing section is configured to calculate a position of the moving work device (18) based on the signal from the rotational position sensor (61), and when the processing section determines that the error has occurred in the meshing, the processing section is configured
to move the moving work device to a predetermined position side, and
to reset the position of the moving work device (18) when the moving work device moves to the predetermined position,
wherein the guide section is a belt comprising multiple belt sections continuously arranged in the predetermined direction,
and the processing section is further configured to:
determine whether the calculated position of the moving work device (18) is within an end portion region of a belt section to determine whether the moving work device moves between two belt sections, and
not execute the determination as to whether the error has occurred in the meshing when the moving work device moves between two belt sections.

2. A mounting system comprising:
the control device (50) according to claim 1;
said mounting-related devices (15) for executing mounting-related processing related to mounting of a component; and
said moving work device.

3. The mounting system according to Claim 2, wherein
the moving work device (18) further includes a motor (58) for driving a driving belt (57) for moving the moving work device in the predetermined direction, and
a second rotational position sensor (59) for detecting a rotational position of the motor (58).

4. The mounting system according to Claim 2 or 3, wherein
the moving work device includes an attaching and detaching section configured to move in the predetermined direction and is configured to attach and detach a feeder (17) that supplies the component to and from an attachment section of the mounting-related device, and an accommodation section for accommodating the feeder.

5. The mounting system according to Claim 4, wherein
the predetermined position is set for each of the multiple mounting-related devices.

6. The mounting system according to any one of Claims 2 to 5, wherein
the rotational position sensor (61) is an encoder.

7. A control method of a moving work device that is used in a mounting system of any one of claims 2 to 6,
the control method comprising:
calculating (S110) an angular acceleration of the rolling member based on a signal from the rotational position sensor; and
determining (S150) that an error has occurred in meshing between the guide section and the rolling member when the angular acceleration of the rolling member is larger than a threshold value,
calculating a position of the moving work device (18) based on the signal from the rotational position sensor (61), and
when it is determined that the error has occurred in the meshing, moving the moving work device to a predetermined position side, and resetting the position of the moving work device (18) when the moving work device moves to the predetermined position,
the control method further comprising:
determining whether the calculated position of the moving work device (18) is within an end portion region of a belt section to determine whether the moving work device moves between two belt sections and
not executing the determination as to whether the error has occurred in the meshing when the moving work device moves between two belt sections.

## Patentansprüche

1. Steuerungsvorrichtung (50), die zum Steuern einer beweglichen Arbeitsvorrichtung (18) ausgeführt ist, die in einem Montiersystem eingesetzt wird, das mit Montieren zusammenhängende Vorrichtungen (15) zum Ausführen mit Montieren zusammenhängender Verarbeitung aufweist, die sich auf Montieren eines Bauteils bezieht,
wobei die bewegliche Arbeitsvorrichtung so ausgeführt ist, dass sie sich in einer vorgegebenen Richtung bewegt, in der die mit Montieren zusammenhängenden Vorrichtungen angeordnet sind, und
wobei die bewegliche Arbeitsvorrichtung ein Rollelement (60) aufweist, das so ausgeführt ist, dass es rollt und dabei mit einem Führungsabschnitt (18b) einer Schiene (18a) in Eingriff ist, die an einer Vorderseite jeder mit Montieren zusammenhängenden Vorrichtung angebracht ist und sich in der vorgegebenen Richtung entsprechend der Bewegung der beweglichen Arbeitsvorrichtung (18) in der vorgegebenen Richtung erstreckt, und
die bewegliche Arbeitsvorrichtung des Weiteren einen Drehpositions-Sensor (61) aufweist, der zum Erfassen einer Drehposition des Rollelementes (60) ausgeführt ist,
wobei die Steuerungsvorrichtung (50) einen Verarbeitungsabschnitt aufweist, der so ausgeführt ist, dass er eine Winkelbeschleunigung des Rollelementes (60) auf Basis eines Signals von dem Drehpositions-Sensor (61) berechnet und feststellt, dass ein Fehler bei Eingriff zwischen dem Führungsabschnitt (18b) und dem Rollelement (60) aufgetreten ist, wenn die Winkelbeschleunigung des Rollelementes (60) über einem Schwellenwert liegt, und
der Verarbeitungsabschnitt so ausgeführt ist, dass er eine Position der beweglichen Arbeitsvorrichtung (18) auf Basis des Signals von dem Drehpositions-Sensor (61) berechnet, und der Verarbeitungsabschnitt so ausgeführt ist, dass er, wenn der Verarbeitungsabschnitt feststellt, dass der Fehler bei dem Eingriff aufgetreten ist,
die bewegliche Arbeitsvorrichtung an eine Seite der vorgegebenen Position bewegt, und
die Position der beweglichen Arbeitsvorrichtung (18) zurücksetzt, wenn sich die bewegliche Arbeitsvorrichtung an die vorgegebene Position bewegt,
wobei der Führungsabschnitt ein Riemen ist, der mehrere Riemenabschnitte umfasst, die durchgehend in der vorgegebenen Richtung angeordnet sind,
und der Verarbeitungsabschnitt des Weiteren ausgeführt ist zum:
Feststellen, ob die berechnete Position der beweglichen Arbeitsvorrichtung (18) innerhalb eines Endabschnitts-Bereiches eines Riemenabschnitts liegt, um festzustellen, ob sich die bewegliche Arbeitsvorrichtung zwischen zwei Riemenabschnitten bewegt, und
Unterlassen der Feststellung dahingehend, ob der Fehler bei dem Eingriff aufgetreten ist, wenn sich die bewegliche Arbeitsvorrichtung zwischen zwei Riemenabschnitten bewegt.

2. Montiersystem, das umfasst:
die Steuerungsvorrichtung (50) nach Anspruch 1;
die mit Montieren zusammenhängenden Vorrichtungen (15) zum Ausführen mit Montieren zusammenhängender Verarbeitung, die sich auf Montieren eines Bauteils bezieht; sowie
die bewegliche Arbeitsvorrichtung.

3. Montiersystem nach Anspruch 2, wobei
die bewegliche Arbeitsvorrichtung (18) des Weiteren einen Motor (58), mit dem ein Antriebsriemen (57) angetrieben wird, um die bewegliche Arbeitsvorrichtung in der vorgegebenen Richtung zu bewegen, sowie
einen zweiten Drehpositions-Sensor (59) aufweist, mit dem eine Drehposition des Motors (58) erfasst wird.

4. Montiervorrichtung nach Anspruch 2 oder 3, wobei
die bewegliche Arbeitsvorrichtung einen Abschnitt zum Anbringen sowie Entfernen, der zum Bewegen in der vorgegebenen Richtung ausgeführt ist und zum Anbringen sowie Entfernen einer Zuführeinrichtung (17), die das Bauteil zuführt, an/von einem Anbringungsabschnitt der mit Montieren zusammenhängenden Vorrichtung ausgeführt ist, sowie einen Aufnahmeabschnitt zum Aufnehmen der Zuführeinrichtung aufweist.

5. Montiersystem nach Anspruch 4, wobei
die vorgegebene Position für jede der mehreren mit Montieren zusammenhängenden Vorrichtungen festgelegt ist.

6. Montiersystem nach einem der Ansprüche 2 bis 5, wobei
der Drehpositions-Sensor (61) ein Codierer ist.

7. Steuerungsverfahren einer beweglichen Arbeitsvorrichtung, die in einem Montiersystem nach einem der Ansprüche 2 bis 6 eingesetzt wird,
wobei das Steuerungsverfahren umfasst:
Berechnen (S110) einer Winkelbeschleunigung des Rollelementes auf Basis eines Signals von dem Drehpositions-Sensor; und
Feststellen (S150), dass ein Fehler bei Eingriff zwischen dem Führungsabschnitt und dem Rollelement aufgetreten ist, wenn die Winkelbeschleunigung des Rollelementes über einem Schwellenwert liegt,
Berechnen einer Position der beweglichen Arbeitsvorrichtung (18)auf Basis des Signals von dem Drehpositions-Sensor (61), und
Bewegen der beweglichen Arbeitsvorrichtung an eine Seite der vorgegebenen Position wenn festgestellt wird, dass der Fehler bei dem Eingriff aufgetreten ist, sowie Zurücksetzen der Position der beweglichen Arbeitsvorrichtung (18), wenn die bewegliche Arbeitsvorrichtung sich an die vorgegebene Position bewegt,
wobei das Steuerungsverfahren des Weiteren umfasst:
Feststellen, ob die berechnete Position der beweglichen Arbeitsvorrichtung (18) innerhalb eines Endabschnitts-Bereiches eines Riemenabschnitts liegt, um festzustellen, ob sich die bewegliche Arbeitsvorrichtung zwischen zwei Riemenabschnitten bewegt, und
Unterlassen der Feststellung dahingehend, ob der Fehler bei dem Eingriff aufgetreten ist, wenn sich die bewegliche Arbeitsvorrichtung zwischen zwei Riemenabschnitten bewegt.

## Revendications

1. Dispositif de contrôle (50) configuré pour contrôler un dispositif de travail mobile (18) utilisé dans un système de montage incluant des dispositifs de montage (15) pour exécuter un traitement de montage relatif au montage d'un composant, dans lequel
le dispositif de travail mobile est configuré pour se déplacer dans une direction prédéterminée dans laquelle les dispositifs de montage sont agencés, et
le dispositif de travail mobile inclut un élément roulant (60) configuré pour rouler tandis qu'il s'engrène avec une section de guidage (18b) d'un rail (18a) attaché à une surface avant de chaque dispositif de montage et s'étendant dans la direction prédéterminée conformément au mouvement du dispositif de travail mobile (18) dans la direction prédéterminée, et
le dispositif de travail mobile inclut en outre un capteur de position rotationnelle (61) configuré pour détecter une position rotationnelle de l'élément roulant (60),
dans lequel le dispositif de contrôle (50) inclut une section de traitement configurée pour calculer une accélération angulaire de l'élément roulant (60) sur la base d'un signal provenant du capteur de position rotationnelle (61) et pour déterminer qu'une erreur s'est produite lors de l'engrènement entre la section de guidage (18b) et l'élément roulant (60) quand l'accélération angulaire de l'élément roulant (60) est supérieure à une valeur seuil, et
dans lequel la section de traitement est configurée pour calculer une position du dispositif de travail mobile (18) sur la base du signal provenant du capteur de position rotationnelle (61), et quand la section de traitement détermine que l'erreur s'est produite lors de l'engrènement, la section de traitement est configurée
pour déplacer le dispositif de travail mobile vers un côté de position prédéterminée, et
pour réinitialiser la position du dispositif de travail mobile (18) quand le dispositif de travail mobile se déplace vers la position prédéterminée,
dans lequel la section de guidage est une courroie comprenant de multiples sections de courroie agencées en continu dans la direction prédéterminée, et la section de traitement est en outre configurée pour :
déterminer si la position calculée du dispositif de travail mobile (18) se trouve ou non dans une région de portion d'extrémité d'une section de courroie afin de déterminer si le dispositif de travail mobile se déplace ou non entre deux sections de courroie, et
ne pas exécuter la détermination du fait que l'erreur s'est produite ou non lors de l'engrènement quand le dispositif de travail mobile se déplace entre deux sections de courroie.

2. Système de montage comprenant :
le dispositif de contrôle (50) selon la revendication 1 ;
lesdits dispositifs de montage (15) destinés à exécuter un traitement de montage relatif au montage d'un composant ; et
ledit dispositif de travail mobile.

3. Système de montage selon la revendication 2, dans lequel le dispositif de travail mobile (18) inclut en outre
un moteur (58) pour entraîner une courroie d'entraînement (57) afin de déplacer le dispositif de travail mobile dans la direction prédéterminée, et
un deuxième capteur de position rotationnelle (59) pour détecter une position rotationnelle du moteur (58).

4. Système de montage selon la revendication 2 ou 3, dans lequel le dispositif de travail mobile inclut
une section d'attachement et de détachement configurée pour se déplacer dans la direction prédéterminée et configurée pour attacher et détacher un dispositif d'alimentation (17) qui approvisionne le composant vers et depuis une section d'attachement du dispositif de montage, et
une section d'accueil pour accueillir le dispositif d'alimentation.

5. Système de montage selon la revendication 4, dans lequel
la position prédéterminée est définie pour chacun des multiples dispositifs de montage.

6. Système de montage selon l'une quelconque des revendications 2 à 5, dans lequel
le capteur de position rotationnelle (61) est un encodeur.

7. Procédé de contrôle d'un dispositif de travail mobile utilisé dans un système de montage selon l'une quelconque des revendications 2 à 6,
le procédé de contrôle comprenant :
le calcul (S110) d'une accélération angulaire de l'élément roulant sur la base d'un signal provenant du capteur de position rotationnelle,
la détermination (S150) du fait qu'une erreur s'est produite lors de l'engrènement entre la section de guidage et l'élément roulant quand l'accélération angulaire de l'élément roulant est supérieure à une valeur seuil,
le calcul d'une position du dispositif de travail mobile (18) sur la base du signal provenant du capteur de position rotationnelle (61), et
quand il est déterminé que l'erreur s'est produite lors de l'engrènement, le déplacement du dispositif de travail mobile vers un côté de position prédéterminée, et la réinitialisation de la position du dispositif de travail mobile (18) quand le dispositif de travail mobile se déplace vers la position prédéterminée,
le procédé de contrôle comprenant en outre :
la détermination du fait que la position calculée du dispositif de travail mobile (18) se trouve ou non dans une région de portion d'extrémité d'une section de courroie afin de déterminer si le dispositif de travail mobile se déplace ou non entre deux sections de courroie, et
la non-exécution de la détermination du fait que l'erreur s'est produite ou non lors de l'engrènement quand le dispositif de travail mobile se déplace entre deux sections de courroie.
